Europäisches Patentamt

European Patent Office

Office européen des brevets

(19)

(11) Publication number: **0 394 573**

A1

## (12) EUROPEAN PATENT APPLICATION

(21) Application number: 89304229.1

(22) Date of filing: 27.04.89

(51) Int. Cl.⁵: **G11C 7/00, B42D 15/02**

(43) Date of publication of application:
31.10.90 Bulletin 90/44

(84) Designated Contracting States:
DE GB

(71) Applicant: NITSUKO CORPORATION
260, Kitamikata Takatsu-ku
Kawasaki-shi Kanagawa 213(JP)

Applicant: DAI NIPPON PRINTING CO., LTD.
1-1-1, Ichigayakaga-cho Shinjuku-ku
Tokyo(JP)

Applicant: SEIYU SHOJI KABUSHIKI KAISHA
2-19-12, Shinjuku Shinjuku-ku
Tokyo(JP)

Applicant: KABUSHIKI KAISHA MICRO
SPEECH TECHNOLOGY
2-19-12, Shinjuku Shinjuku-ku
Tokyo(JP)

(72) Inventor: Horinokita, Shigetoshi
c/o Nitsuko Ltd. 260 Kitamikata Takatsu-ku
Kawasaki-shi Kanagawa-ken(JP)
Inventor: Mihara, Katsuyuki c/o Dai Nippon
Printing Co., Ltd
1-1-1, Ichigaya-Kagacho
Shinjuku-ku Tokyo(JP)
Inventor: Takahashi, Shojirou
c/o Seiyu Shoji Kabushiki Kaisha 2-19-12,
Shinjuku
Shinjuku-ku Tokyo(JP)

(74) Representative: Votier, Sidney David et al
CARPMAELS & RANSFORD 43, Bloomsbury
Square
London WC1A 2RA(GB)

(54) **Voice message write device.**

(57) A voice message write device (10) for writing a voice message in a memory of a voice synthesizing card (1) which can be used for a message card, a greeting card, a voice cablegram, a voice mail etc. includes an input section for receiving an analog voice signal, an analog-to-digital conversion section for converting the analog voice signal applied to the input section to a digital voice signal, a memory (48, 49) for storing the digital voice signal, a write control circuit (47) for controlling writing of the digital voice signal in this memory in accordance with a write operation, a read control circuit (47) for controlling reading of the digital voice signal from this memory in accordance with a playback operation, a digital-to-analog conversion section for converting the digital voice signal read from the memory to an analog voice signal, a loudspeaker (22) for sounding the converted analog voice signal, and a digital voice signal output section for reading out the digital voice signal from the memory and supplying it to a voice synthesizing card in accordance with a transfer operation. The voice messsage is transferred to the voice synthesizing card only after test hearing the voice message whereby the voice message can be written in the voice synthesizing card in a good recording condition.

FIG. 1

## Voice Message Write Device

This invention relates to a voice message write device for writing a voice message in a memory of a voice synthesizing card and, more particularly, to a voice message write device comprising a memory for test hearing of a recorded voice message.

A voice synthesizing card is a card used for a communication card, a Christmas card, a message card, a greeting card etc. which comprises an internal memory for storing a desired voice message in the form of digital data and a small loudspeaker for sounding the voice message read from the internal memory by turning-on of a photo-switch or a push-button switch.

It is necessary for the voice synthesizing card to have a voice message stored in its internal memory. A voice message write device therefore is required to write a voice message in the itnernal memory of the voice synthesizing card.

A prior art voice message write device has a recording section for once recording a voice message therein and transfers the voice message recorded in this recording section to an internal memory of a voice synthesizing card. There is also a prior art voice message write device which has a cassette tape recorder for recording a voice message prerecorded in a tape in the recording section of the recording device.

Since the prior art voice message write devices are devices in which a voice message which has once been recorded in the recording section of the devices is transferred to an internal memory of a voice synthesizing card in accordance with a transferring operation, a voice message is recorded on a voice synthesizing card even if state of recording of the voice message recorded in the recording section of the devices is not sufficient. This gives rise to a problem that such insufficient state of recording can be found only when the voice message recorded in the voice synthesizing card is sounded from the loudspeaker of the voice synthesizing card.

This is particularly disadvantageous in a case where an OTPROM (one time programmable ROM) is employed as an internal memory of a voice synthesizing card. In an OTPROM, data can be recorded only once and cannot be erased or rewritten, this ROM is suitable for an internal memory of a voice synthesizing card because it is suited for eternal preservation of a voice message and besides manufacturing cost thereof is relatively low. If a voice message is once written in the OTPROM in a poor recording condition, the voice synthesizing card is wasted as an inferior card and recording of the voice message must be made again on a new voice synthesizing card. For this reason, it is extremely difficult to employ an OTPROM as an internal memory of a voice synthesizing card so long as the prior art voice message write devices are used for writing a voice message on the voice synthesizing card.

It is, therefore, an object of the invention to overcome the above described disadvantage of the prior art voice message write devices and provide a voice message write device comprising a memory for test hearing of a recorded voice message and being capable of once storing voice message data to be ultimately written in a voice synthesizing card and transferring this voice message data to the voice synthesizing card after test hearing the voice message for enabling the voice synthesizing card to store the voice message data recorded in a sufficient recording condition.

For achieving this object, the voice message write device according to the invention comprises an input section for receiving an analog voice signal, an analog-to-digital conversion section for converting the analog voice signal applied to the input section to a digital voice signal, a memory for storing the digital voice signal, write control means for controlling writing of the digital voice signal in this memory in accordance with a write operation, read control means for controlling reading of the digital voice signal from this memory in accordance with a playback operation, a digital-to-analog conversion section for converting the digital voice signal read from the memory to an analog voice signal, a loudspeaker for sounding the converted analog voice signal, and a digital voice signal output section for reading out the digital voice signal from the memory and supplying the digital voice signal to a voice synthesizing card in accordance with a transfer operation.

According to the invention, the voice signal applied from the input section and converted to a digital signal is once written in a memory in accordance with a write operation and thereafter is read from the memory, converted to an analog signal and sounded in accordance with a playback operation before being ultimately transferred to the voice synthesizing card. This enables the recording condition of the voice signal recorded in the memory to be detected before the vioce signal is written in the voice synthesizing card so that storage in the memroy can be erased and recording of the voice signal can be made again if the recording condition is insufficient whereby production of a voice synthesizing card with a poorly recorded voice message can be prevented. Accordingly, adoption of an OTPROM as an internal memory of a voice synthesizing card is made feasible so that a voice synthesizing card for eternal preservation purpose can be recorded and the cost of manufacture of the voice synthesizing card can be reduced.

In one aspect of the voice message write device according to the invention, the digital voice signal output section comprises means for judging, by means of a predetermined empty terminal among input and output terminals of the voice synthesizing card which has been set in said voice message write device, whether or not predetermined information has been imparted to the voice synthesizing card thereby enabling the digital voice signal to be supplied to the voice synthesizing card only when the predetermined information has been imparted to the voice synthesizing card. By this arrangement, it can be judged, in writing a voice message in a voice synthesizing card, whether or not the voice synthesizing card is a designated product so that use of an imitation card in the voice message write device can be prevented.

For likewise preventing use of an imitation voice synthesizing card, in another aspect of the voice message write device according to the invention, the digital voice signal output section comprises means for accessing an internal memory of the voice synthesizing card and judging whether or not predetermined information has been written in said internal memory thereby enabling the digital voice signal to be written in said internal memory only when the predetermined information has been written in the internal memory.

Further, according to the invention, there is provided a voice synthesizing card comprising an interface for receiving a digital voice signal from outside, memory means for storing the received digital voice signal, voice synthesizing means for synthesizing an analog voice signal from the voice signal stored in the memory, amplifying means for amplifying the synthesized analog voice signal, a loudspeaker for sounding the amplified analog voice signal, power source for supplying power to the respective means, a voice synthesizing board on which a switch for turning on and off the power source as required is mounted, description space means for enabling contents of the stored voice signal to be described by letters or the like in a predetermined location on the voice synthesizing board, and recording confirmation means for confirming that the voice signal has been stored in the memory means.

According to the invention, description can be made with letters or the like on a description space on the voice synthesizing card after the voice message has been stored so that contents of the voice message can be confirmed easily. Since the contents of the voice message can be confirmed by the description, it is not necessary to play back the voice message from the card for confirmation of the contents thereof and this contributes to saving of battery power. Since record confirmation means is automatically checked by the voice message write device, voice message stored in a voice synthesizing card is not erased even if the card has been erroneously set in the voice message write device.

Preferred embodiments of the invention will now be described with reference to the accompanying drawings.

In the accompanying drawings,

Fig. 1 is a block diagram showing an embodiment of the voice message write device according to the invention;

Fig. 2 is a perspective view of an outside appearance of the same embodiment;

Fig. 3 is a flow chart showing an example of a voice synthesizing card judging operation;

Fig. 4 is a flow chart showing another example of the voice synthesizing card judging operation;

Fig. 5 is a plan view of an embodiment of a voice synthesizing card applied to the voice message write device according to the invention;

Fig. 6 is a rear view of the same embodiment;

Figs. 7A and 7B are perspective views showing a voice communication card incorporating the voice synthesizing card;

Figs. 8A and 8B are perspective views showing another example of the voice communication card;

Figs. 9A and 9B are perspective views showing still another example of the voice communication card;

Fig. 10A is a plan view showing another embodiment of the voice synthesizing card; and

Fig. 10B is a sectional view of a part of the voice synthesizing card of Fig. 10A.

An embodiment of the voice synthesizing card will first be described with reference to Fig.s 5 and 6.

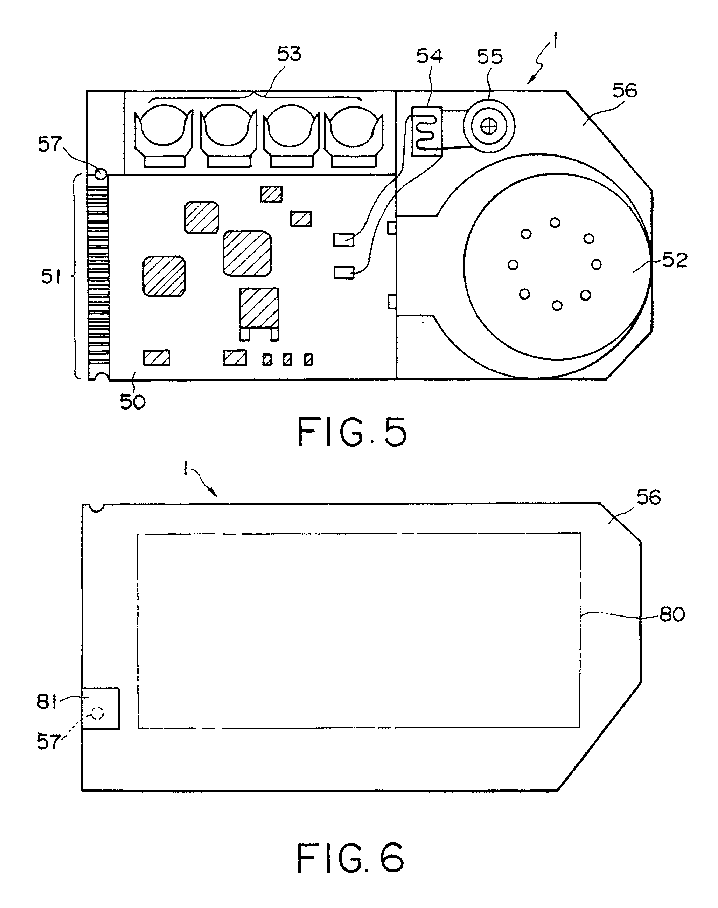

Fig. 5 is a plan view of a voice synthesizing card 1 and Fig. 6 is a rear view thereof.

In Fig. 5, the voice synthesizing card 1 is provided with a voice synthesizing board 50 having an interface terminal 51 for receiving input voice message data. On the voice synthesizing board 50, there is provided a voice circuit including a memory such as EPROM for storing voise message data, a voice synthesizing LSI for synthesizing an analog voice signal from the voice message data stored in the memory and an IC for amplifying the synthesized voice signal. The voice synthesizing card 1 further comprises a loudspeaker 52, a battery 53, a photo switch 54 and a push switch 55 for turning on and off the power source for the voice circuit on the voice synthesizing board 50.

The photo switch 54 is used for automatically operating the voice circuit when an outer cover of a voice communication card to be described later is opened.

The push switch 55 is used for operating the voice circuit manually instead of the photo switch 54. The voice circuit may be operated only when both the photo switch 54 and the push switch 55 have been turned on. On the rear surface of the voice synthesizing board 50 is attached a support 56 made of a plastic sheet or the like material. There is provided a description space 80 on the rear surface of this support 56 for recording the contents of voice message to be stored in the memory such as the name and address of the user.

A record hole 57 is formed in the voice synthesizing board 50 and a support 56 for indicating that voice message has been stored in the memory. A tape 81 or the like is normally applied over the record hole 57. This tape 81 is removed by the operator after the voice message has been written in the voice synthesizing card. By this arrangement, the record hole 57 can be seen from the outside of the voice synthesizing card 1 so that storage of the voice message in the voice synthesizing card can be readily confirmed. The record hole 57 is optically detected in a detection section of the voice message write device. Upon detection of the record hole 57 of the voice synthesizing card set in the voice message write device, the device prohibits writing in the memory of the voice synthesizing card 1. This will prevent erasing of voice message already written in the memory of a voice synthesizing card even if the voice synthesizing card is erroneously set in the voice message write device.

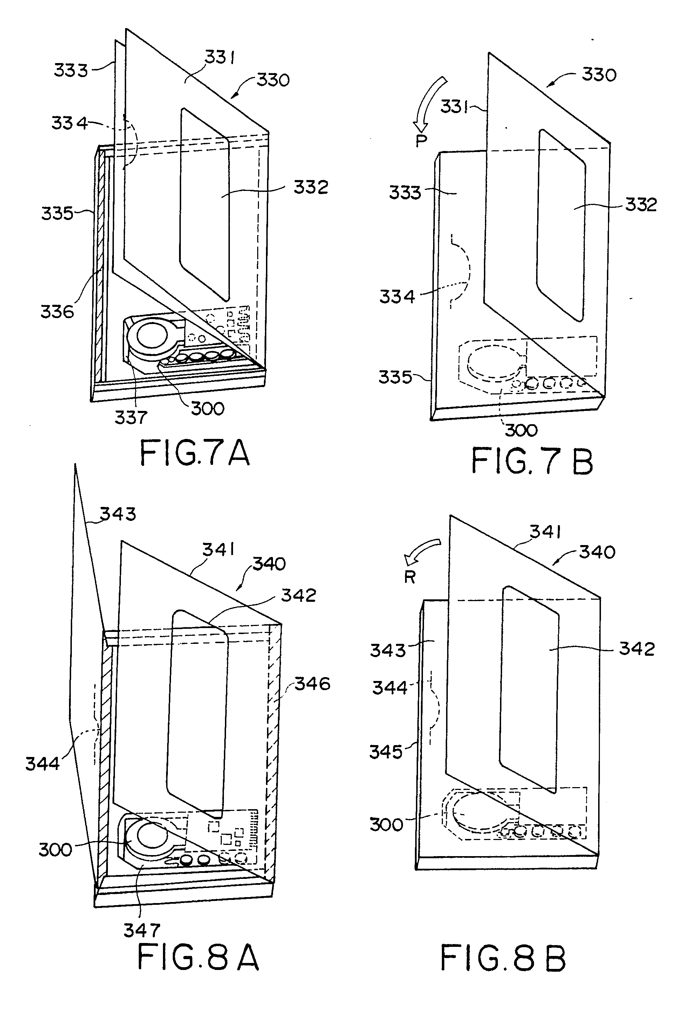

Figs. 7A and 7B show an example in which the voice synthesizing card according to the invention has been used for a voice communication card 330. This voice communication card 330 has, as shown in Fig. 7A, a card receiving section 337 for receiving the voice synthesizing card 1 in one end portion of a base 335 made of cardboard or the like material. A double adhesive tape 336 is applied around the base 225. As shown in Fig. 7A, an inner cover 333 is adhered to the double adhesive tape 336 so as to hide the voice synthesizing card 1 as shown in Fig. 7B. A weak adhesive tape may be partially used as the double adhesive tape 336 so that this portion may be stripped off for facilitating replacement of the battery. The card receiving section 337 may be provided on the rear side of the base 335 so that the voice synthesizing card 1 may be embedded from the rear side. Desired information such as words which are the same as the contents of the voice message is written on the inner cover 333. A cutting 334 is made in the free end portion of the inner cover 333 so as to lock the outer cover 331 by folding the outer cover 331 in the direction of arrow P in Fig. 7B and inserting the end portion thereof in the cutting 334. A window 332 is formed in the central portion of the outer cover 331 to enable the description on the inner cover 333 to be visually confirmed from outside.

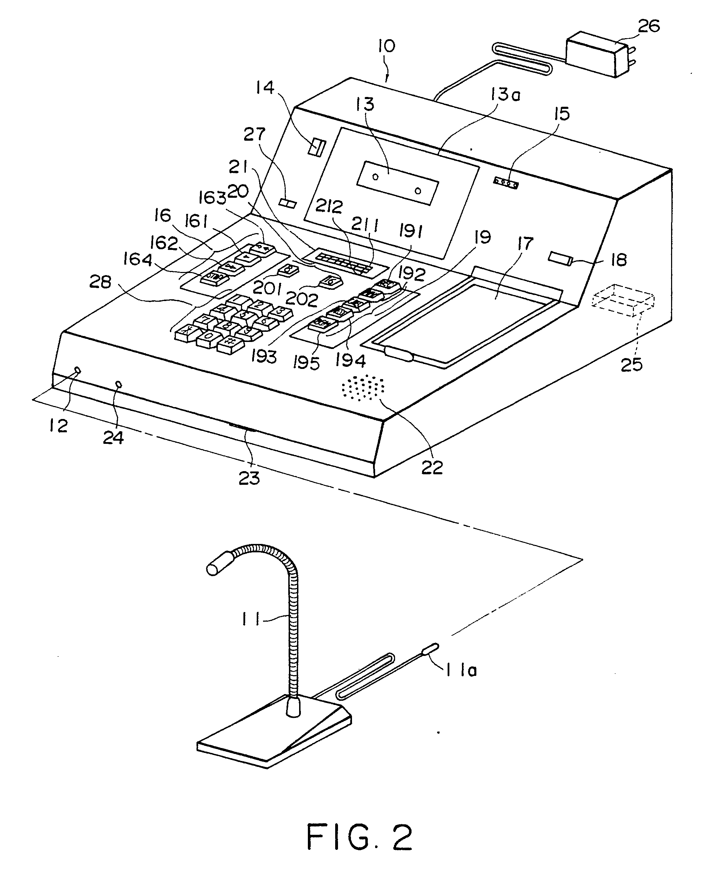

Referring now to Fig. 2, a voice message write device 10 according to the invention once records a voice message prerecorded on a cassette tape (not shown) or applied from a microphone 11 in a recording section of the device 10 to be described later and has the voice message recorded in the recording section transferred to an internal memory (not shown) of the voice synthesizing card 1.

The voice message write device of this embodiment is capable of writing a voice message only in a designated type of voice synthesizing card (the invention is of course not limited to this but the voice message write device may be adapted to use an undesignated type of voice synthesizing card). In this embodiment, the designated type of voice synthesizing card has a predetermined empty terminal among input and output terminals, i.e., interface terminals, provided with a positive potential from a battery incorporated in the device 10. The voice synthesizing card 1 in this example has the interface terminals consisting of 32 pins and some of them are empty terminals. The number of pins is not limited to his but it may be 7-8 or 12-16.

The voice message write device 10 has an insertion hole 12 in which a connection pin 11a of the microphone 11 can be inserted and a cassette tape recorder 13 for reproducing a voice message recorded in a cassette tape. The cover 13a of the cassette tape recorder 13 can be opened by depressing an eject button 14. The number of winding of the cassette tape is indicated by a counter 15. Operations of the cassette tape recorder 13, i.e., playback, fast feeding, rewinding and stop) are made by manipulation of operation buttons 16 (i.e., playback button 161, fast feeding button 162, rewinding button 163 and stop button 164).

The voice message write device 10 has also a card attachment 17 for receiving a voice synthesizing card 1 to have the voice message recorded in the recording section of the device 10 written in the internal memory of the voice synthesizing card 1. The card attachment 17 can be opened by pushing an attachment eject button 18. Writing of a voice message in the internal memory of the voice synthesizing card 1 is operated by manipulating message buttons 19 (i.e., record button 191, playback button 192, write button 193, reset button 194 and BGM (background music) button 195). Time for recording a voice message in the recording section of the voice message write device 10 is selected by recording time selection buttons 20 (i.e., first recording time selection button 201 and second recording time selection button 202). If the operator wishes to select recording time of 8 seconds, he depresses the first recording time selection button 201 whereas if he wishes to select recording time of 16 seconds, he depresses the second recording time selection button 202. Time elapsed during recording of a voice message in the recording section in the voice message write device 10 is indicated by a first bar graph 211 of a display board 21 and the sound level is indicated by a bar graph 212 of the display board 21.

Reproduced sound of a voice message from the cassette tape recorder 13 or a voice message recorded in the recording section of the voice message write device 10 is sounded from a loudspeaker 22. The volume of the loudspeaker 22 is adjusted by a volume 23.

The voice message write device 10 has also an outside voice source insertion hole 24 for inputting a voice message from an outside voice source other than the cassette tape recorder 13 and the microphone 11, e.g., a voice message from an open reel deck, radio, record player or the like and a write adaptor connector 25 for connecting a write adaptor (not shown) used when a voice message is to be written in plural voice synthesizing cards simultaneously. It is also possible to record a voice message in this voice message write device 10 through a telephone line by additionally providing a telephone line unit in this device 10.

A power source adaptor 26 converts commercial ac voltage to a desired dc voltage to supply power to the voice message write device 10. There are also provided a power switch 27 and ten keys 28 for inputting numerical values of necessary information.

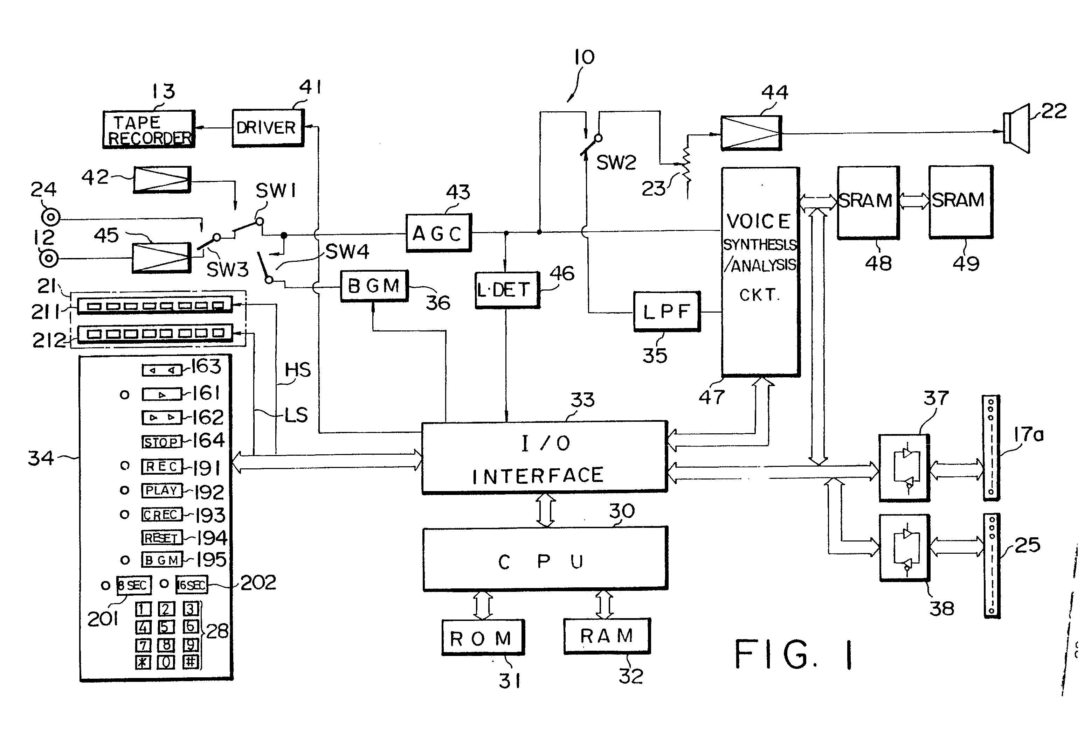

Referring to Fig. 1, the voice message write device 10 comprises a CPU (microprocessor) 30 for performing a system control of the entire system, a read-only memory (ROM) 31 storing a control program and a random-access memory (RAM) 32 in which control data and other data are written and read out as required. These components are connected to one another by data buses. The CPU 30 is connected to other circuits to be described later through an input-output (I/O) interface 33 and data buses whereby data is transmitted and received between the CPU 30 and the other circuits.

One of the other circuits connected to the I/O interface 33 is an operation button section 34 comprising operation buttons 16 (i.e., playback buttons 161, fast feeding button 162, rewinding button 163 and stop button 164), message buttons 19 (i.e., record button 191, playback button 192, write button 193, reset button 194 and BGM button 195), recording time selection buttons 20 (i.e., the first and second recording time selection buttons 201 and 202) and ten keys 28. An operation command applied from the operation button section 34 is transmitted to the CPU 30 through the data bus and the I/O interface 33 and the CPU 30 processes this operation command in accordance with the control program stored in the ROM 31.

To the I/O interface 33 is connected a driver circuit 41 which drives the cassette tape recorder 13. A voice message reproduced from the cassette tape recorder 13 is supplied to an amplifier 42. The output of the amplifier 42 is connected to a normally open contact of a switch SW1. A fixed contact of the switch SW1 is connected to an input of an AGC (automatic gain control) circuit 43 whose output in turn is connected to a normally open contact of a switch SW2. A fixed contact of the switch SW2 is connected to an input of an amplifier 44 through a volume 23 whose output in turn is connected to the loudspeaker 22.

A normally closed contact of the switch SW1 is connected to a fixed contact of a switch SW3. A normally open contact of the switch SW3 is connected to the outside voice source insertion hole 24 and a normally closed contact of the switch SW3 is connected to the output of an amplifier 45. The input of the amplifier 45 is connected to the insertion hole 12.

The output of the AGC circuit 43 is connected to a level detection circuit 46 for detecting a sound level of an output signal of the AGC circuit 43. Further, the output of the AGC circuit 43 is connected to a voice synthesis and analysis circuit 47 for synthesizing or analyzing a voice message. The voice synthesis and analysis circuit 47 comprises an analog-to-digital conversion section for converting an analog voice signal from the AGC circuit 43 to a digital voice signal. Whether a voice message is synthesized or analyzed in the voice synthesis and analysis circuit 47 is designated by a control command supplied through the I/O interface 33 and the data bus from the CPU 30 which constitutes the write control means and the read control means in the present invention. When this control command is a voice analysis command, the voice synthesis and analysis circuit 47 analyzes the output of the AGC circuit 43 and stores a digital voice signal which is data resulting from the analysis in SRAMs (static random-access memory) 48 and 49 which constitute the recording section of the voice message write device 10 through the data bus. When the control command is a voice synthesis command, the voice synthesis and analysis circuit 47 synthesizes a voice message by reading out the digital voice signal from the SRAMs 48 and 49 and converting it to an analog voice signal by a digital-to-analog conversion section incorporated in the circuit 47 and thereafter delivers the analog voice signal to an LPF (low-pass filter) 35. The ouptut of the LPF 35 is connected to a normally closed contact of the switch SW2.

To the I/O interface 33 is also connected a BGM generator 36 which generates a BGM signal. The output of the BGM generator 36 is connected to a fixed contact of the switch SW4. A normally open contact of the switch SW4 is connected to the input (fixed contact of the switch SW1) of the AGC circuit 43.

The I/O interface 33 is further connected through the data bus to the SRAMs 48 and 49 and input and output control circuits 37 and 38. The input and output control circuits 37 and 38 are respectively connected to the input and output terminal 18a and the write adaptor connector 25 of the card attachment 17 (Fig. 2). The input and output control circuits 37 and 38 constitute the digital voice signal output section for reading out the digital voice signal from the memory and supplying the digital voice signal to the voice synthesizing card. When, accordingly, a command to write a voice message in the internal memory of the voice synthesizing card 1 has been given to the SRAMs 48 and 49, the voice message stored in the SRAMs 48, 49 is supplied through the input and output control circuit 37 to the input and output terminal 17a of the card attachment 17 or through the input and output control circuit 38 to the write adaptor connector 25 and written in the internal memory of the voice synthesizing card 1.

The level detection signal supplied from the level detection circuit 46 is supplied to the CPU 30 through the I/O interface 33. Upon receipt of this level detection signal, the CPU 30 supplies a display signal LS indicating the sound level to the second bar graph 212 through the I/O interface 33. The second bar graph 212 displays the sound level in response to the display signal LS.

Operations of the switches SW1 through SW4 will now be described.

The switch SW3 is driven by an unillustrated mechanism when a jack of an outside voice source has been inserted in the outside voice source insertion hole 24 and is switched to the normally open contact side (outside voice source insertion hole 24 side). Upon detection by the CPU 30 of depression of the playback button 161 of the operation buttons 16, the CPU 30 changes over the switches SW1 and SW'' to the normally open contact side. Upon detection by the CPU 30 of depression of the playback button 161 of the operation buttons 16, the CPU 30 changes over the switches SW2 and SW4 to the normally open contact side.

In the voice message write device 10 of the present embodiment, the CPU 30 does not start recording merely by a record start operation to be described later but starts recording only when a voice signal having a sound level exceeding a predetermined level has been detected by the level detection circuit 46.

A manner of recording a voice message in the SRAMs 48 and 49 of the voice message write device 10 will now be described.

The operator first depresses either one of the first and second recording time selection buttons 201 and 202. If the operator wishes to record his voice message directly from him, he inserts the connection pin 11a of the microphone 11 in the insertion hole 12. If he wishes to record a voice message prerecorded in a cassette tape, he sets the cassette tape in the tape recorder 13.

After preparation of recording has been completed in this manner, the operator depresses the record button 191 if he wishes to record his voice message directly through the microphone 11. If he wishes to record a voice message prerecorded in the cassette tape, he depresses the record button 191 and then depresses the playback button 161 of the operation buttons 16.

The CPU 30 starts a recording processing upon detection of the depression of the operaton button 16.

After this recording operation, the CPU 30 performs recording in the SRAMs 48 and 49 in the manner described below.

In a case where a voice message from the microphone 11 is to be recorded, the input voice message is applied to the voice message write device 10 from the insertion hole 12 and supplied to the AGC circuit 43 through the amplifier 45 and the switch SW1.

In a case where a voice message prerecorded in a cassette tape is to be recorded, the switches SW1 and SW2 are changed over to the normally open contact side upon detection by the CPU 30 of depression of the playback button 161 of the operation buttons 16 and a playback drive control signal is supplied to the driver circuit 41. The cassette tape recorder 13 is driven by the driver circuit 41 to play back the voice message recorded on the cassette tape set in the cassette tape recorder 13. The reproduced voice signal is amplified by the amplifier 42 and thereafter is applied to the AGC circuit 43 through the switch SW1.

The voice signal applied to the AGC circuit 43 is automatically adjusted in its volume therein. The sound level of the output signal of the AGC circuit 43 is detected by the level detection circuit 46. The level detection circuit 46 supplies a level detection signal to the CPU 30 through the I/O interface 33. In response to this level detection signal, the CPU 30 supplies the display signal HS indicating the sound level to the second bar graph 212 through the I/O interface 33. The sound level is thereby indicated on the second bar graph 212.

In a case where the voice message is one prerecorded in the cassette tape, the switch SW2 is inverted so that the output signal of the AGC circuit 43 is sounded from the loudspeaker 22 through the switch SW2, volume 23 and amplifier 44.

The CPU 30 judges whether the sound level is larger than the predetermined level or not on the basis of this level detection signal. If the sound level is larger than the predetermined level, the CPU 30 supplies a voice analysis command to the voice synthesis and analysis circuit 47 through the I/O interface 33. Writing of the voice message in the SRAMs 48 and 49 is thereby started.

In response to this voice analysis command, the voice synthesis and analysis circuit 47 analyzes the output signal of AGC circuit 43 after converting it to a digital signal and writes the result of the analysis in the SRAMs 48 and 49 as a digital voice signal.

Simultaneously, the CPU 30 inspects time elapsed during recording and supplies the signal HS indicating time elapsed for recording to the first bar graph 211 through the I/O interface 33. The first bar graph 211 displays the time elapsed for recording.

When the recording time of 8 seconds has been selected by the first recording time selection button 201, the voice message is written in the SRAM 48 only. When the recording time of 16 seconds has been selected by the second recording time selection button 202, the voice message is written in both the SRAMs 48 and 49.

If the operator wishes to insert a BGM in the voice message in the recording of the voice message, he depresses the BGM button 195 and also depresses one of the ten keys 28 for selecting a desired music.

Upon lapse of recording time selected by the first recording time selection button 201 or the second recording time selection button 202, the CPU 30 supplies an end command to the voice synthesis and analysis circuit 47 whereby recording of the voice message in the SRAMs 48 and 49 is completed.

After completion of recording, the operator depresses the playback button 192 of the message buttons 19 for confirming whether or not the voice message has been recorded in the SARMs 48 and 49 in a good condition. Upon detection of the depression of the message button 19, the CPU 30 supplies a voice synthesis command to the voice synthesis and analysis circuit 47. In response to this voice synthesis command, the voice synthesis and analysis circuit 47 reads out the voice signal recorded in the SRAMs 48 and 49 and supplies it to the LPF 35 after converting it to an analog voice signal. The LPF 35 cuts off high frequency components of this analog voice signal. The output of the LPF 35 is supplied through the switch SW2, volume 23 and amplifier 44 to the loudspeaker 22 and sounded therefrom as a voice for test hearing.

If the operator judges that the recording has been made in good condition by the test hearing, he performs writing of the voice message in the voice synthesizing card.

In the present embodiment, upon setting of a voice synthesizing card in the voice message write device, an operation for judging whether the set card is a designated voice synthesizing card or not is performed prior ot writing of a voice message in the card.

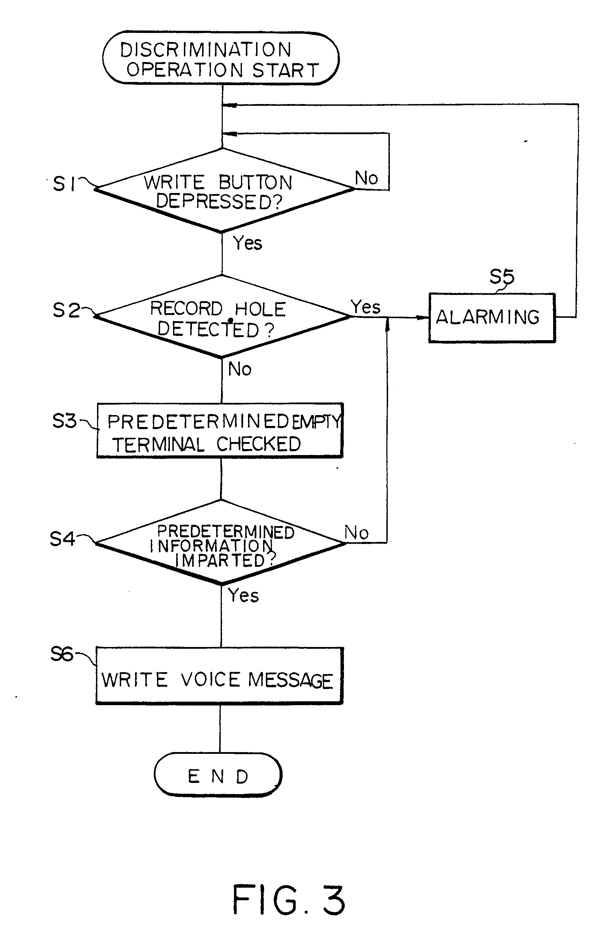

An example of such judging operation will be described with reference to Fig. 3.

For writing the digital voice signal recorded in the SRAMs 48 and 49 in the internal memory of the voice synthesizing card 1, the operator sets the voice synthesizing card in the card attachment 17. Then, he depresses the write button 193 of the message buttons 19. Upon detection of depression of the write button 193 (step S1), the CPU 30 detects presence or absence of the record hole 57 by the optical detection section as was previously described with reference to Fig. 5 (step S2). If the record hole 57 is not detected, the CPU 30 checks a predetermined empty terminal among empty terminals in the interface terminals 51 (Fig. 5) of the voice synthesizing card through the I/O interface 33, input and output control circuit 37 and input and output terminal 17a (step S3). The CPU 30 judges whether or not predetermined information, i.e., positive potential of the battery 53 (Fig. 5) has been given to the predetermined empty terminal (step S4). If the positive potential is not detected from the predetermined empty terminal, the CPU 30 judges that the set voice synthesizing card is not a designated voice synthesizing card but an imitation card and prohibits subsequent writing operation while informing the operator that writing is not possible by a suitable alarming (step S5). As this alarming, for example, a buzzar may be sounded once when writing has been made normally and twice when writing is not possible.

If the CPU 30 has detected positive potential, it supplies a write command to the SRAMs 48 and 49 and sets the input and output control circuit 37 to an output mode. The digital voice signal stored in the SRAMs 48 and 49 is supplied to the input and output terminal 17a of the card attachment 17 through the input and output control circuit 37 and written in the internal memory of the voice synthesizing card 1 (step S6). The internal memory of this voice synthesizing card consists, for example, of an EPROM or an OTPROM. In this manner, according to this embodiment, writing of a voice message is made only on a designated voice synthesizing card.

In the above described embodiment, description has been made with respect to a case where one of several empty terminals is used. Alternatively, all empty terminals may be utilized for the same purpose or a key word may be given by providing positive potential to some of the empty terminals.

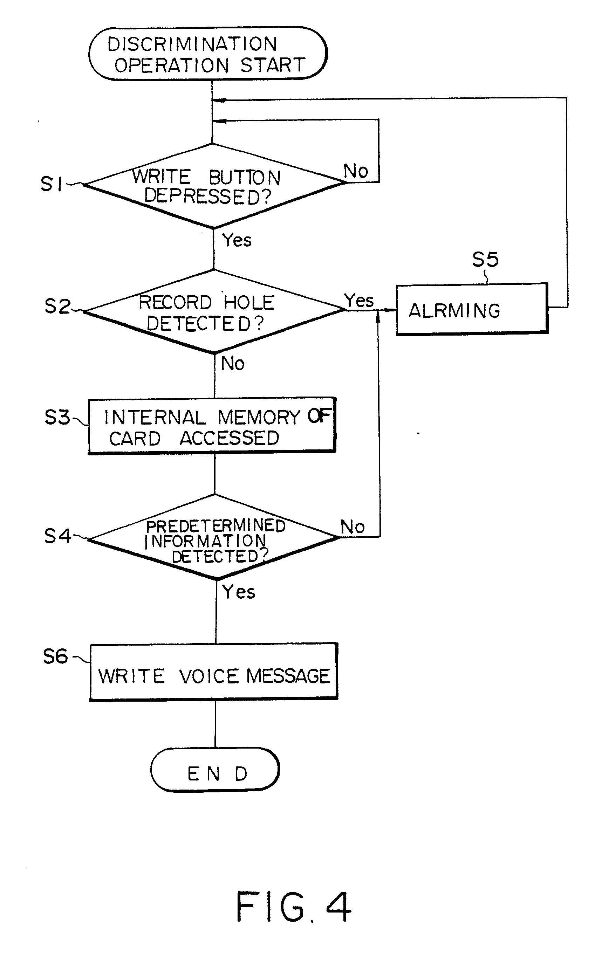

Another example of the voice synthesizing card judging operation will be described with reference to Fig. 4. In this example, steps S1 and S2 are the same as in the example shown in Fig. 4. When the record hole 57 has been detected, the CPU 30 accesses a predetermined location in the internal memory of the voice synthesizing card 1 through the I/O interface 33, input and output control circuit 37 and input and output terminal 17a (step S3). That is, the CPU 30 judges whether or not predetermined information has been imparted to the predetermined location in the internal memory of the voice synthesizing card 1 (step S4). If the CPU 30 has not detected the predetermined information, it judges that the set voice synthesizing card is an imitation card and prohibits subsequent writing of the voice message while informing the operator that writing is not possible by a suitable alarming (step S5).

If the CPU 30 has detected the predetermined information, it supplies a write command to the SRAMs 48 and 49 and sets the input and output control circuit 37 to the output mode. The digital voice signal recorded in the SRAMs 48 and 49 is supplied to the input and output terminal 17a of the card attachment 17 through the input and output control circuit 37 whereby the digital voice signal is written in the internal memory of the voice synthesizing card 1(step S6). An arrangement is made so that, in writing a digital voice signal in the voice synthesizing card 1, clock on the side of the voice synthesizing card 1 and clock on the side of the voice message write device 10 are synchronized with each other. In this manner, the voice message write device 10 writes a voice message only on a designated voice synthesizing card.

As described, according to the above described embodiments, whether a set card is a designated voice synthesizing card is judged prior to writing of a voice message in the voice synthesizing card whereby use of an imitation voice synthesizing card can be prevented.

After a voice message is written in the internal memory of the voice synthesizing card 1, the voice synthesizing card 1 is detached from the device 10. The operator removes the tape 81 from the record hole 57 of the voice synthesizing card 1 so that the fact that the voice message has been recorded can be visually confirmed. The operator also writes contents of the voice message and other necessary matters in the description space 80 on the rear side of the card 1. By using the voice synthesizing card 1 having the recorded voice message, a voice communication card 300 as shown in Figs. 7A and 7B is produced. In producing the voice communication card 300, assembly of the card 300 is made while the description on the inner cover 333 is checked with the description on the description space 80 of the card 1 so that work efficiency is improved. If a voice synthesizing card 1 on which a voice message has already been recorded is erroneously set in the voice message write device 10, the erroneous setting can be checked by the record hole 57 so that further writing can be prevented. The voice communication card 300 thus produced is delivered to a user in the form of a voice telegram, a voice mail, a voice photograph album or other media.

In the above described example, the voice communication card 300 is assembled in such a manner that the outer cover 331 and the inner cover 333 are aligned to each other. Alternatively, the voice communication card may be assembled in the following manner.

In a voice communication card 340 shown in Fig. 8A, the voice synthesizing card 1 is housed in a housing section 347 in a base 345 and a double adhesive tape 346 is adhered to the edge portion of the base 345. An inner cover 343 having a cutting 344 is adhered to the base 345 from the left side as viewed in Fig. 8B and an outer cover 341 having a window 342 is folded in the direction of arrow R from the right side as viewed in Fig. 8B and locked by means of the cutting 344.

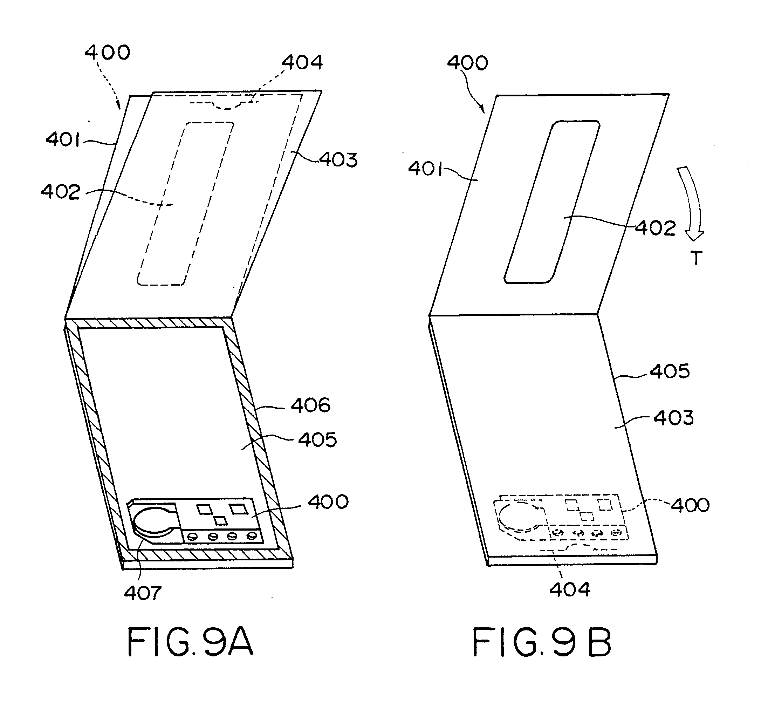

Figs. 9A and 9B show another example of the voice communication card. In a voice communication card 400 of this example, the voice synthesizing card 1 is housed in a housing section 407 in a base 405 and a double adhesive tape 406 is adhered to the edge portion of the base 405. An inner cover 403 having a cutting 404 is adhered to the base 405 from above as shown in Fig. 9B and an outer cover 401 having a window 402 is folded from above in the direction of arrow T and locked by means of the cutting 404. In the above described examples, the record hole 57 of the voice synthesizing card 1 is previously formed and the tape 81 is adhered on the record hole 57. Alternatively, the voice message write device 10 may have a hole forming means therein and the record hole 57 may be formed by such hole forming means automatically after writing a voice message in the voice synthesizing card 1. Alternatively further, a color tape or the like may be adhered to the card 1 instead of forming the record hole 57 and this tape may be removed after writing of a voice message in the card 1 for enabling visual confirmation of storage of the voice message in the card 1. In this latter case, the voice message write device 10 may be provided with a recorded information detection section of a light reflection type.

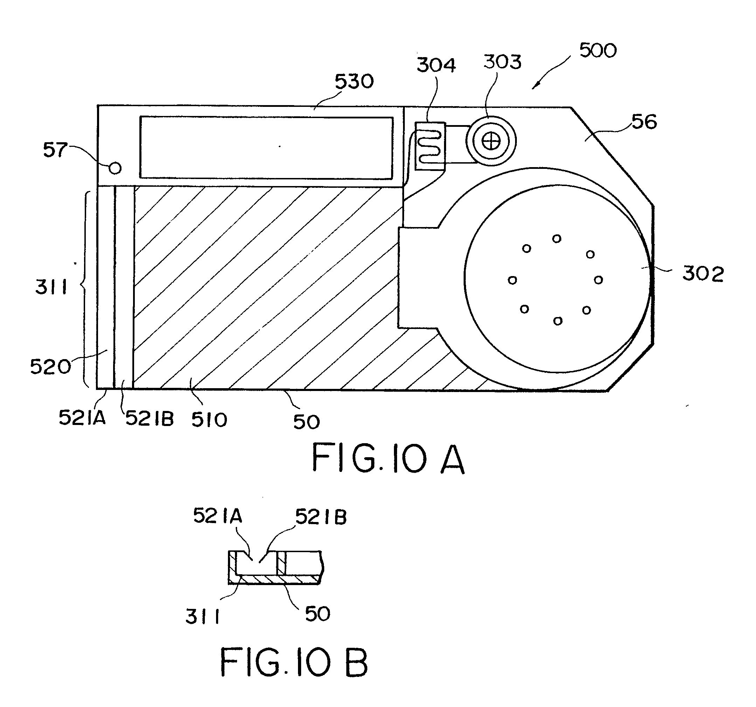

Figs. 10A and 10B show an example of a voice synthesizing card having water proof and electromagnetic shield properties. This voice synthesizing card 500 has, as shown in Fig. 10A, a voice synthesizing board 50 on a support 56 in the same manner as in the above described example. A resin sheet 510 which has a water-proof property and an electromagnetic shield effect (e.g., carbonate resin blended with carbon) is attached on a main portion of this voice synthesizing board 50 (i.e., integrated circuit etc.) for preventing invasion of water. This main portion may be molded by using the same resin as the above-mentioned resin. A lid 530 having a water-proof property is provided in a portion of the battery 53 mounted in the voice synthesizing board 50 to facilitate replacement of the battery 53. A water-proof lid 520 made of plastic films 521A and 521B is provided over the interface terminals 311 so that this lid 520 is opened as shown in Fig. 10B when the voice synthesizing card 500 has been set in the voice message write device 10. A transparent plastic sheet may be provided over the photo switch 304 or the portion of the photo switch 304 may be molded with a transparent resin for imparting the photo switch 304 with water-proof property. A water-proof element may be used for the push switch 303 and the loudspeaker 302. By providing such water-proof and electromagnetic shield properties to the voice synthesizing card 500, damage to the card 500 caused by washing or static electricity can be prevented.

## Claims

1. A voice message write device comprising:
an input section for receiving an analog voice signal;
an analog-to-digital conversion section for converting the analog voice signal applied to the input section to a digital voice signal;
a memory for storing the digital voice signal;
write control means for controlling writing of the digital voice signal in this memory in accordance with a write operation;
read control means for controlling reading of the digital voice signal from this memory in accordance with a read operation;
a digital-to-analog conversion section for converting the digital voice signal read from the memory to an analog voice signal;
a loudspeaker for sounding the converted analog voice signal; and
a digital voice signal output section for reading out the digital voice signal from the memory and supplying the digital voice signal to a voice synthesizing card in accordance with a transfer operation.

2. A voice message write device as defined in claim 1 wherein said input section is a tape recorder.

3. A voice message write device as defined in claim 1 wherein said input section is a microphone.

4. A voice message write device as defined in claim 1 wherein said input section is a telephone line.

5. A voice message write device as defined in claim 1 which further comprises means for displaying time elapsed or remaining time during writing of the digital voice signal in said memory.

6. A voice message write device as defined in claim 1 wherein said write control means causes writing of the digital voice signal to be started when the input level of the voice signal is larger than a predetermined value.

7. A voice message write device as defined in claim 1 which further comprises BGM generation means for generating a BGM signal and synthesis means for synthesizing the BGM signal generated by this BGM generation means and the analog voice signal applied to said input section.

8. A voice message write device as defined in claim 1 wherein said digital voice signal output section comprises means for judging, by means of a predetermined empty terminal among input and output terminals of the voice synthesizing card which has been set in said voice message write device, whether or not predetermined information has been imparted to the voice synthesizing card thereby enabling the digital voice signal to be supplied to the voice synthesizing card only when the predetermined information has been imparted to the voice synthesizing card.

9. A voice message write device as defined in claim 1 wherein said digital voice signal output section comprises means for accessing an internal memory of the voice synthesizing card and judging whether or not predetermined information has been written in said internal memory thereby enabling the digital voice signal to be written in said internal memory only when the predetermined information has been written in the internal memory.

10. A voice synthesizing card comprising:
an interface for receiving a digital voice signal from outside;
memory means for storing the received digital voice signal;
voice synthesizing means for synthesizing an analog voice signal from the voice signal stored in the memory;
amplifying means for amplifying the synthesized analog voice signal;
a loudspeaker for sounding the amplified analog voice signal;
power source for supplying power to the respective means;

a voice synthesizing board on which a switch for turning on and off the power source as required is mounted;

description space means for enabling contents of the stored voice signal to be described by letters or the like in a predetermined location on the voice synthesizing board; and

recording confirmation means for confirming that the voice signal has been stored in the memory means.

11. A voice synthesizing card as defined in claim 10 whrein said memory means is an OT-PROM.

FIG. I

FIG. 2

```
        ┌─────────────────────┐
        │   DISCRIMINATION    │
        │  OPERATION START    │
        └─────────────────────┘
```

FIG. 3

EP 0 394 573 A1

```
        ┌────────────────────────┐
        │  DISCRIMINATION        │
        │  OPERATION START       │
        └────────────────────────┘
                    │
S1 ────◇ WRITE BUTTON DEPRESSED? ◇──── No ────┐
                    │ Yes                      │
                    │                          │
S2 ────◇ RECORD HOLE DETECTED? ◇──── Yes ──┐   │
                    │ No                    │   │
                    │               ┌───────┴───┴──┐
                    │         S5    │   ALRMING    │
                    │               └──────────────┘
        ┌──────────────────────────┐
S3 ─────│ INTERNAL MEMORY OF        │
        │ CARD  ACCESSED            │
        └──────────────────────────┘
                    │
S4 ────◇ PREDETERMINED INFORMATION DETECTED? ◇──── No ──┘
                    │ Yes
        ┌──────────────────────────┐
S6 ─────│ WRITE  VOICE  MESSAGE     │
        └──────────────────────────┘
                    │
              ┌───────────┐
              │   END     │
              └───────────┘
```

FIG. 4

FIG.5

FIG.6

FIG.7A

FIG.7B

FIG.8A

FIG.8B

FIG.9A

FIG.9 B

FIG.IO A

FIG.IO B

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 548 428 (ESTEREL-COTE D'AZUR) * Page 1, line 9 - page 2, line 18; page 5, line 17 - page 8, line 20; figures 1-2,6-8 * | 1,3 | G 11 C 7/00 B 42 D 15/02 |
| A | | 10,11 | |
| X | DE-A-3 605 690 (WEYERS) * Column 2, line 9 - column 3, line 23; figures 1-3 * | 10 | |
| A | | 11 | |
| A | EP-A-0 034 024 (SWARZTRAUBER) * Page 6, line 16 - page 8, line 24; page 21, line 19 - page 23, line 7; figures 1-7 * | 1-4,10-11 | |
| A | DE-A-3 532 259 (WEIGL) * Column 1, line 24 - column 2, line 2 * | 1,3,10,11 | |

TECHNICAL FIELDS
SEARCHED (Int. Cl.5)

G 11 C 7/00
G 06 K 19/00
B 42 D 15/00
B 42 D 3/00

The present search report has been drawn up for all claims

| Place of search | Date of completion of the search | Examiner |
|---|---|---|
| THE HAGUE | 22-12-1989 | GEOGHEGAN C.H.B. |